Europäisches Patentamt

European Patent Office

Office européen des brevets

(11) Veröffentlichungsnummer: **0 433 758 A2**

## (12) EUROPÄISCHE PATENTANMELDUNG

(21) Anmeldenummer: **90123229.8**

(22) Anmeldetag: **04.12.90**

(51) Int. Cl.5: **H01L 27/02**

(30) Priorität: **19.12.89 DE 3941931**

(43) Veröffentlichungstag der Anmeldung:
**26.06.91 Patentblatt 91/26**

(84) Benannte Vertragsstaaten:
**DE FR GB IT NL**

(71) Anmelder: **Siemens Aktiengesellschaft**
**Wittelsbacherplatz 2**
**W-8000 München 2(DE)**

(72) Erfinder: **Becker, Burkhard, Dr.**
**Schlüsselbergstrasse 8**
**W-8000 München 80(DE)**

(54) **Eingangschutzstruktur für integrierte Schaltungen.**

(57) Die vorgeschlagene Eingangsschutzstruktur für integrierte Schaltungen enthält mindestens einen aus zwei komplementären Transistoren (3, 4) aufgebauten Thyristor sowie einen integrierten Widerstand (13b), der parallel zur Basis (13a)-Emitter (14a)-Strecke des zweiten Transistors (4) geschaltet ist.

Durch eine spezielle Anordnung und Struktur der den Thyristor bildenden Zonen in einem Halbleitersubstrat (10) wird aufgrund einer Kombination von Transistor- und Thyristor-Wirkung eine hohe Belastbarkeit gegen elektrostatische Entladungen beider Polaritäten erreicht.

FIG 2

EP 0 433 758 A2

## EINGANGSSCHUTZSTRUKTUR FÜR INTEGRIERTE SCHALTUNGEN

Die vorliegende Erfindung betrifft eine Eingangsschutzstruktur für integrierte Schaltungen nach dem Oberbegriff des Patentanspruchs 1.

Integrierte Schaltungen benötigen einen sicheren Schutz gegen elektrostatische Entladungen. Zu diesem Zweck werden sie mit Eingangsschutzstrukturen versehen, einige dem Stand der Technik entsprechende Strukturen sind in der DE-OS 36 16 394 erläutert. Eine Eingangsschutzstruktur für bipolare integrierte Schaltungen mit einer Isolation benachbarter Bauelemente durch Diffusionsgebiete, die einen Thyristor und einen integrierten Widerstand enthält, ist aus der DE-OS 32 01 933 bekannt. Der integrierte Widerstand ist hier parallel zu einem der beiden den Thyristor bildenden Transistoren geschaltet. Da die angegebene Schutzstruktur auf einer vorwiegend lateralen Arbeitsweise des Thyristors beruht, können Oberflächendurchbrüche nicht vermieden werden. Ferner bietet die Schaltung nur Schutz gegen positive Hochspannungen am Eingang.

Der vorliegenden Erfindung liegt daher die Aufgabe zugrunde, eine Eingangsschutzstruktur für integrierte Schaltungen anzugeben, die unter Vermeidung de obengenannten Nachteile einen hohen Schutz gegen elektrostatische Entladungen beider Polaritäten aufweist.

Diese Aufgabe wird bei einer Eingangsschutzstruktur nach dem Oberbegriff des Patentanspruchs 1 erfindungsgemäß durch die Merkmale des kennzeichnenden Teils des Patentanspruchs 1 gelöst. Weiterbildungen der Erfindung sind Gegenstand von Unteransprüchen.

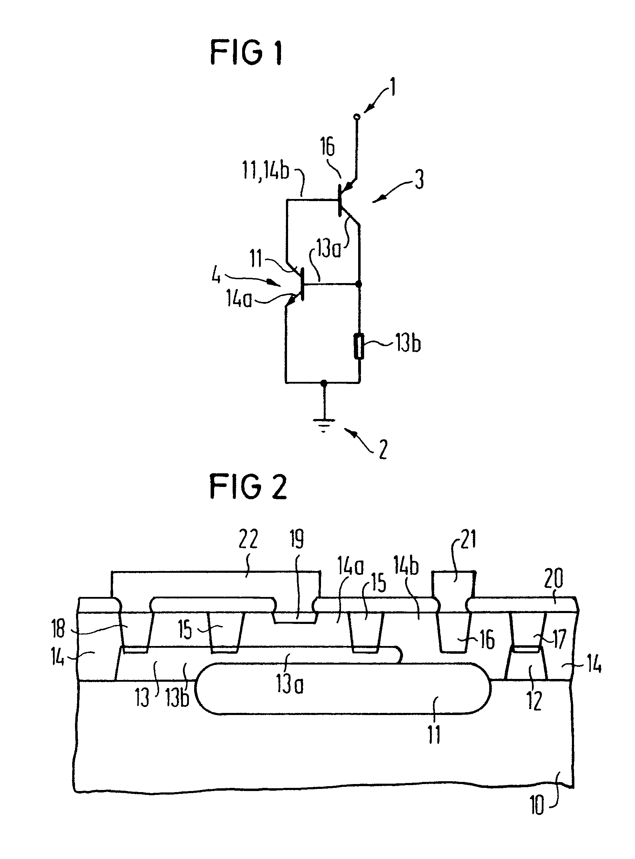

Die Erfindung wird im folgenden anhand eines Ausführungsbeispiels gemäß den Figuren 1 und 2 der Zeichnung näher erläutert. Es zeigt:

- FIG 1 ein Ersatzschaltbild einer Eingangsschutzstruktur in Form eines durch zwei Transistoren gebildeten Thyristors und eines integrierten Widerstandes gemäß der Erfindung, womit ein Schutz gegen elektrostatische Entladungen beider Polaritäten möglich ist, und
- FIG 2 eine Ausführungsform der Realisierung einer Eingangsschutzstruktur nach Figur 1 in einem Halbleitersystem in schematischer Darstellung.

Gemäß Figur 1 liegt zwischen einem Eingangsanschluß 1 einer integrierten Schaltung, insbesondere einer bipolaren integrierten Schaltung, und einem Anschluß für ein Referenzpotential 2, insbesondere Masseanschluss, eine Schutzstruktur, die durch einen ersten Transistor 3 und einen zweiten Transistor 4, welche zu einem Thyristor gekoppelt sind, und einen integrierten Widerstand 13b, der parallel zur Basis - Emitter-Strecke des zweiten Transistors 4 geschaltet ist, gebildet wird. Dabei sind die Basis 13a des zweiten Transistors 4 über den integrierten Widerstand 13b und der Emitter 14a des zweiten Transistors 4 mit dem Anschluß des Referenzpotentials 2 verbunden. Der Emitter 16 des ersten Transistors 3 ist mit dem Eingangsanschluß 1 verbunden. Der erste Transistor 3, bei dem es sich vorzugsweise um einen pnp-Transistor handelt, ist mit seiner Basis 11, 14b an den Kollektor 11 des zweiten, vorzugsweise npn-Transistors 4 angeschlossen und mit seinem Kollektor 13a an die Basis 13a des zweiten Transistors 4. Zwei derart miteinander verkoppelte Transistoren stellen einen Thyristor dar.

Die Bezugszeichen in Figur 1 sind in Übereinstimmung mit den Bezugszeichen in Figur 2 des im folgenden zu erläuternden Halbleitersystems gewählt, in dem die Schutzstruktur realisiert ist. Die Schutzstruktur im Halbleitersystem nach Figur 2 wird im folgenden anhand der schematischen Verfahrensabfolge bei der Herstellung erläutert.

Ausgangspunkt für die Herstellung des Halbleitersystems nach Figur 2 ist ein Halbleitersubstrat 10 eines ersten Leitungstyps, bei dem es sich vorzugsweise um den p-Leitungstyp handelt.

In dieses Halbleitersubstrat 10 wird in bekannter Weise zunächst eine insbesondere hochdotierte Zone des entgegengesetzten zweiten Leitungstyps, im vorliegenden Beispiel also des n-Leitungstyps, eindiffundiert, durch die mit den nachfolgenden Herstellungsschritten eine vergrabene Zone 11 (buried layer) gebildet wird. Weiterhin werden in das Halbleitersubstrat 10 Zonen mit dem Leitungstyp des Halbleitersubstrats eindiffundiert, welche Teilzonen 12 einer noch zu vervollständigenden, an sich üblichen Isolationsstruktur bilden.

Vorzugsweise gleichzeitig mit der Eindiffusion der Teilzonen 12 wird in das Halbleitersubstrat 10 und die vergrabene Zone 11 eine untere Diffusionszone 13 mit dem ersten Leitungstyp eindiffundiert, so daß diese einen Teil des Halbleitersubstrats 10 und den größten Teil der vergrabenen Zone 11 überdeckt. Anschließend wird in an sich üblicher Weise auf das insoweit behandelte Halbleitersubstrat 10 eine epitaktische Schicht 14 des zweiten Leitungstyps, im vorliegenden Beispiel also des n-Leitungstyps, aufgebracht.

Nachfolgend werden in einem weiteren Diffusionsschritt Zonen 15, 16, 17 und 18 des ersten Leitungstyps in die epitaktische Schicht 14 eingebracht, wobei die erste obere Diffusionszone 15 als geschlossener Ring bis in die untere Diffusionszone 13 hineinreicht und einen Teilbereich 14a der epitaktischen Schicht 14 vollständig umschließt, so daß dieser Teilbereich 14a von der übrigen epitaktischen Schicht 14 isoliert ist. Erfindungsgemäß wird die ringförmige erste obere Diffusionszone 15 und insbesondere der eingeschlossene Teilbereich 14a so angeordnet, daß sie sowohl oberhalb eines Teils 13a der unteren Diffusionszone 13 als auch oberhalb der vergrabenen Zone 11 liegen. Die zweite obere Diffusionszone 17 reicht in die untere Teilzone 12 der Isolationsstruktur hinein und vervollständigt so die Isolation der Schutzstruktur von benachbarten Bauelementen. Ferner wird durch sie und die erste obere Diffusionszone 15 ein Teilbereich 14b der epitaktischen Schicht 14 eingegrenzt, der, wie in der Figur 2 genauer zu erkennen ist, nach unten im wesentlichen durch die vergrabene Zone 11 und nur in geringem Maße durch die untere Diffusionszone 13 oder das Halbleitersubstrat 10 begrenzt ist. In diesem Bereich 14b der epitaktischen Schicht 14 ist die dritte obere Diffusionszone 16 so angeordnet, daß sie oberhalb der vergrabenen Zone 11 endet. Die vierte obere Diffusionszone 18 ist außerhalb der ringförmigen ersten oberen Diffusionszone 15 so ausgebildet, daß sie in die untere Diffusionszone 13 hineinreicht. Der Kontakt zwischen oberer Diffusionszone 18 und unterer Diffusionszone 13 liegt dabei vorzugsweise an einer Stelle, an der die untere Diffusionszone auf dem Halbleitersubstrat 10, nicht auf der vergrabenen Schicht 11, aufliegt. Der zwischen der ersten oberen Diffusionszone 15 und der vierten oberen Diffusionszone 18 liegende Teil der unteren Diffusionszone 13 ist mit 13b bezeichnet.

Schließlich wird in den Teilbereich 14a der epitaktischen Schicht 14 eine insbesondere hochdotierte Zone 19 vom Leitungstyp der epitaktischen Schicht 14, im vorliegenden Beispiel also vom n-Leitungstyp, eindiffundiert. Zur Isolation des gesamten Halbleitersystems wird entweder eine aus isolierendem Material bestehende Schicht 20 aufgebracht oder die bereits bei den Temperaturschritten der Diffusionsprozesse entstandene Schicht 20 aus Siliziumoxyd verwendet. Diese isolierende Schicht 20 wird so strukturiert, daß die dritte 16 und die vierte obere Diffusionszone 18 sowie die hochdotierte Zone 19 anschließbar sind. Die Zone 16 wird mit einer Leitbahn 21 als Anschluß für den Eingang und die Zonen 18 und 19 mit einer Leitbahn 22 als gemeinsamer Anschluß für das Referenzpotential 2 versehen.

Aufgrund der vorstehend erläuterten Zonenstruktur ergibt sich im Halbleitersystem ein dem ersten Transistor 3 in Figur 1 entsprechender pnp-Transistor, dessen Emitter durch die dritte obere Diffusionszone 16, dessen Basis durch den Bereich 14b der epitaktischen Schicht 14 und die vergrabene Zone 11 und dessen Kollektor durch die untere Diffusionszone 13, insbesondere den Teilbereich 13a, gebildet wird. Sein Emitter 16 ist über die Leitbahn 21 an den Eingang 1 anschließbar. Der zweite npn-Transistor 4 gemäß Figur 1 wird im Halbleitersystem gebildet durch den Bereich 14a der epitaktischen Schicht 14 als Emitter, den direkt darunterliegenden Teilbereich 13a der unteren Diffusionszone 13 als Basis und die Buried-Layer-Zone 11 als Kollektor. Über die hochdotierte Zone 19 als Emitterkontaktzone und die Leitbahn 22 ist der Emitter 14a des zweiten Transistors 4 an das Referenzpotential 2 anschließbar. Die Basis des einen Transistors ist mit dem Kollektor des anderen Transistors verbunden bzw. identisch, und umgekehrt. Insgesamt stellt die Zonenfolge also einen pnpn-Thyristor dar, bestehend aus:
dritter oberer Diffusionszone 16 - Teilbereich 14b der epitaktischen Schicht 14 einschl. vergrabener Zone 11 - Teilbereich 13a der unteren Diffusionszone 13 - Teilbereich 14a der epitaktischen Schicht 14.

Der integrierte Widerstand 13b gemäß Figur 1 wird durch den in Figur 2 dargestellten Teilbereich 13b der unteren Diffusionszone 13, der durch die erste obere Diffusionszone 15 und die vierte obere Diffusionszone 18 begrenzt wird, gebildet. Er ist über die vierte obere Diffusionszone 18 und die Leitbahn 22 gemeinsam mit dem Emitter 14a des zweiten Transistors 4 an das Referenzpotential 2 anschließbar. Die Größe des integrierten Widerstandes 13b wird also durch die Dimensionierung des Teilbereichs 13b der unteren Diffusionszone 13 eingestellt.

Bei positiven Spannungsimpulsen am Eingang 1 arbeitet die Eingangsschutzstruktur als Thyristor. Durch den integrierten Widerstand 13b wird der Kollektorstrom des ersten Transistors 3 in einen Basisstrom des zweiten Transistors 4 und einen Substratstrom aufgeteilt. Das Verhältnis der beiden Anteile bestimmt den Haltestrom des Thyristors, der Substratstrom entzieht der Basis 13a des zweiten Transistors 4 den für die Aufrechterhaltung der Thyristor-Wirkung notwendigen Haltestrom. Im Grenzfall eines unendlich hohen Widerstandes 13b liegt eine reine Thyristor-Arbeitsweise vor, während im Grenzfall eines unendlich niedrigen Widerstandes 13b eine reine Transistor-Arbeitsweise über den ersten Transistor 3 eintritt.

Bei negativen Spannungsimpulsen am Eingang befindet sich der gesamte Thyristor im gesperrten Zustand. Der Impuls muß über den ersten Transistor 3 sowie den integrierten Widerstand 13b abgeleitet werden, d. h. der pnp-Transistror 3 arbeitet im Inversbetrieb. Hierfür darf der Wert des integrierten Widerstandes 13b nicht zu groß sein. Ein guter Kontakt der unteren Diffusionszone 13 zum Substrat bzw. zum Masseanschluß ermöglicht die Ableitung des Spannungsimpulses über die pnp-Strecke. Ein Oberflächendurchbruch wird verhindert, da weder die erste obere Diffusionszone 15 noch die zweite obere Diffusionszone 17 direkt angeschlossen sind. Der Impuls wird vielmehr über die untere Diffusionszone 13 abgeleitet.

Durch den notwendigerweise relativ kleinen Wert des integrierten Widerstandes 13b kann die Thyristor-Wirkung für positive Spannungsimpulse stark unterdrückt werden und der Schwellwert des Haltestroms hohe Werte in der Größenordnung von 50 mA annehmen. Die Schutzwirkung gegen positive Spannungsimpulse wird dadurch aber nicht vermindert.

Durch den Aufbau der Schutzstruktur mit einer großflächigen unteren Diffusionszone 13 als Kollektor des ersten Transistors 3 sowie den mit der hochdotierten Emitter-Kontaktzone 19 versehenen Bereich 14a der epitaktischen Schicht 14 wird eine Ableitung von Spannungsimpulsen einerseits in die Tiefe des Halbleitersystems und andererseits durch den Bereich 14a wieder an die Oberfläche des Halbleitersystems gewährleistet. Die Aufteilung der einzelnen Strompfade in Transistor-Wirkung und Thyristor-Wirkung gewährleistet sowohl eine hohe Belastbarkeit der Schutzstruktur selbst als auch eine hohe Schutzwirkung. Die Verwendbarkeit der Struktur wird durch die der jeweiligen Spezifikation anzupassende Durchbruchspannung des Übergangs zwischen vergrabener Zone 11 und unterer Diffusionszone 13 bestimmt.

**Ansprüche**

1. Eingangsschutzstruktur für integrierte Schaltungen, welche
    - zwischen einen Eingang (1) und einen Anschluß für ein Referenzpotential (2) geschaltet ist,
    - in einem Halbleitersubstrat (10) angeordnet ist,
    - mindestens einen ersten Transistor (3) und einen zweiten Transistor (4), die durch gegenseitige Kopplung von Basis und Kollektor zu einem Thyristor verschaltet sind, und einen integrierten Widerstand (13b) enthält,
    **dadurch gekennzeichnet, daß** die Basis (13a) des zweiten Transistors (4) über den integrierten Widerstand (13b) gemeinsam mit dem Emitter (14a) des zweiten Transistors (4) an den Anschluß für das Referenzpotential (2) angeschlossen ist, und der Emitter (16) des ersten Transistors (3) an den Eingang (1) angeschlossen ist.

2. Eingangsschutzstruktur nach Anspruch 1, **dadurch gekennzeichnet,** daß der Emitter des ersten Transistors (3) durch eine dritte obere Diffusionszone (16) seine Basis durch einen Teilbereich (14b) einer epitaktischen Schicht (14) und eine vergrabene Zone (11), und sein Kollektor durch einen Teilbereich (13a) einer unteren Diffusionszone (13) gebildet wird.

3. Eingangsschutzstruktur nach Anspruch 2, **dadurch gekennzeichnet,** daß die untere Diffusionszone (13) die vergrabene Schicht (11) und das Halbleitersubstrat (10) teilweise überdeckt.

4. Eingangsschutzstruktur nach einem der Ansprüche 1 bis 3, **dadurch gekennzeichnet,** daß der Emitter des zweiten Transistors (4) durch einen weiteren Teilbereich (14a) der epitaktischen Schicht (14), seine Basis durch den unterliegenden Teilbereich (13a) der unteren Diffusionszone (13), und sein Kollektor als vergrabener Kollektor durch die vergrabene Zone (11) gebildet wird.

5. Eingangschutzstruktur nach Anspruch 4, **gekennzeichnet** durch eine zur Oberfläche des Halbleitersubstrats (10) weitgehend vertikale Anordnung der den zweiten Transistor (4) bildenden Zonen (19, 14a, 13a, 11) und einen im wesentlichen vertikalen Strompfad innerhalb des zweiten Transistors (4).

6. Eingangsschutzstruktur nach einem der Ansprüche 1 bis 5, **dadurch gekennzeichnet,** daß der als Emitter des zweiten Transistors (4) wirkende Teilbereich (14a) der epitaktischen Schicht (14) durch eine ihn umschließende ringförmige erste obere Diffusionszone (15) ohne direkten Anschluß an den Eingang (1) oder an das Referenzpotential (2) von der übrigen epitaktischen Schicht (14) isoliert ist.

7. Eingangsschutzstruktur nach einem der Ansprüche 1 - 6, **dadurch gekennzeichnet,** daß der integrierte Widerstand (13b) durch einen weiteren, außerhalb der ringförmigen ersten oberen Diffusionszone liegenden Teilbereich der unteren Diffusionszone (13) gebildet wird.

8. Eingangsschutzstruktur nach einem der Ansprüche 1 - 7, **dadurch gekennzeichnet,** daß die oberen Diffusionszonen (15, 16, 17, 18) eine stärkere Dotierung als die untere Diffusionszone (13) und denselben Leitungstyp wie diese aufweisen.

# FIG 1

# FIG 2